# EUROPEAN PATENT APPLICATION

(11) **EP 4 203 075 A1**
(43) Date of publication of application: **28.06.2023**
(21) Application number: 22213910.7
(22) Date of filing: 15.12.2022
(51) Int. Cl.: H01L 31/0352, G04C 10/02, G04G 17/06, H02S 40/34

(54) **ELECTRONIC DEVICE**

(30) Priority: 22.12.2021 JP 2021207879
(71) Applicant: Casio Computer Co., Ltd., Tokyo 151-8543 (JP)
(72) Inventor: SAITO, Yuta, Tokyo, 205-8555 (JP); UCHIBAYASHI, Sae, Tokyo, 205-8555 (JP)
(74) Representative: Plougmann Vingtoft a/s

(57) **Abstract**

An electronic device (1) includes a solar cell (16, 16a), a wiring board (161, 161a), a connector (162, 162a), a first circuit (2010), a second circuit (2020) and a fixing member (23). The wiring board includes a feeder wiring (1611) connected to the solar cell. The connector is continuous with the wiring board and includes a feeder electrode (1622) electrically connected to the feeder wiring. The first circuit includes a first electrode (2011) and a first wiring (2012) continuous with the first electrode. The second circuit includes a second electrode (2021) and a second wiring (2022) continuous with the second electrode. The fixing member fixes the feeder electrode, the first electrode and the second electrode in a state in which the electrodes are superposed on top of one another, to electrically connect each one of the electrodes to another one or more of the electrodes.

## Description

### BACKGROUND OF THE INVENTION

### Field of the Invention

The present disclosure relates to an electronic device including a solar cell.

### Description of the Related Art

Some low-power electronic devices or portable electronic devices, such as electronic watches, are provided with panel-shaped solar cells (solar panels) and operate with electric power generated by the solar cells. Among these, small electronic devices are required to make light efficiently incident on their solar cells and transmit generated electric power to power supply circuits of their circuit boards or the like.

In JP 2013-213719 A, as a technology for easily arranging solar panels with flexibility, there is disclosed a power generating device including: two solar sections each having a plurality of solar panels arranged flatwise; and a bendable coupling section connecting these to one another, wherein the coupling section is integrated with the solar sections.

However, this technology has a problem that the area for connecting and fixing a solar cell (solar panel(s)) to a circuit board or the like takes up much space.

Objects of the present disclosure includes providing an electronic device capable of supplying generated electric power in a more space-saving manner, namely with less space.

### SUMMARY OF THE INVENTION

An electronic device includes:
a solar cell;
a wiring board including a feeder wiring connected to the solar cell;
a connector continuous with the wiring board and including a feeder electrode electrically connected to the feeder wiring;
a first circuit including a first electrode and a first wiring continuous with the first electrode;
a second circuit including a second electrode and a second wiring continuous with the second electrode; and
a fixing member that fixes the feeder electrode, the first electrode and the second electrode in a state in which the electrodes are superposed on top of one another, to electrically connect each one of the electrodes to another one or more of the electrodes.

### BRIEF DESCRIPTION OF THE DRAWING

The accompanying drawings, which are incorporated in and constitute a part of the specification, illustrate embodiments, and together with the general description given above and the detailed description of the embodiments given below, serve to explain the principles of the present disclosure, wherein:
FIG. 1A is a plane/top view of an electronic timepiece that is an electronic device according to an embodiment(s);
FIG. 1B is a bottom view of the electronic timepiece as the electronic device according to the embodiment;
FIG. 2 is a sectional view of the electronic timepiece;
FIG. 3A is an illustration to explain a solar panel;
FIG. 3B is an illustration to explain the solar panel;
FIG. 4 is an illustration to explain fixation of a connector;
FIG. 5A is an illustration to explain a solar panel and a component(s) for connecting and fixing the solar panel, according to a modification;
FIG. 5B is an illustration to explain the solar panel and the component for connecting and fixing the solar panel, according to the modification;
FIG. 6A shows a modification of objects to be co-fastened; and
FIG. 6B shows the modification of objects to be co-fastened.

### DETAILED DESCRIPTION OF THE PREFERRED EMBODIMENT

Hereinafter, one or more embodiments of the present disclosure will be described with reference to the drawings.

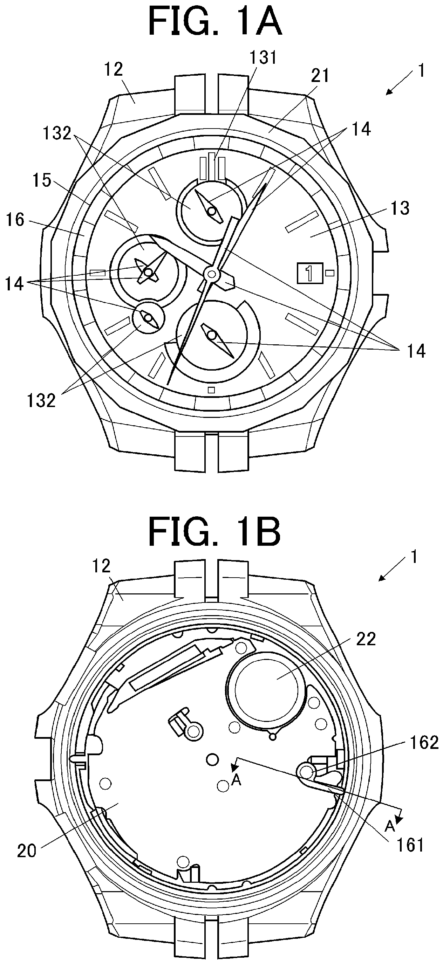

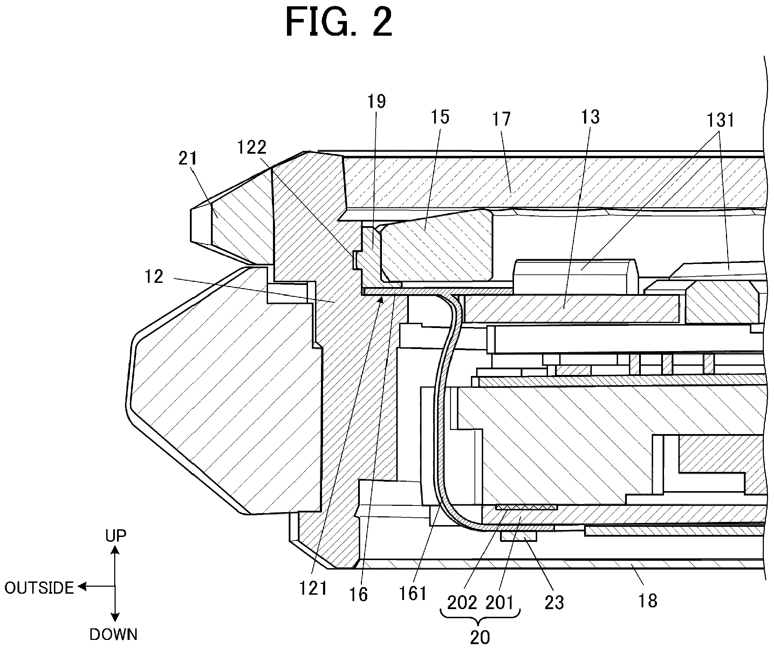

FIG. 1A is a plane/top view of an electronic timepiece 1 that is an electronic device according to an embodiment(s). FIG. 1B is a bottom view of the electronic timepiece 1 as the electronic device according to the embodiment. The bottom view of FIG. 1B shows the electronic timepiece 1 with a back cover 18 (shown in FIG. 2) detached. As to this electronic timepiece 1, the side shown by the plane/top view of FIG. 1A is the upper side, and the side shown by the bottom view of FIG. 1B is the lower side.

The electronic timepiece 1 includes a case 12, a dial 13, hands 14, a dial cover 15 (parting member), and a board 20 (circuit board). Through the dial cover 15, a solar panel 16 (solar cell) disposed thereunder is visible. The hands 14 are covered, from the above, with a light-transmitting, transparent in this embodiment, crystal 17 (light-transmitting member, shown in FIG. 2). The hands 14 are disposed between the dial 13 and the crystal 17 (i.e., on the dial 13) so as to be rotatable in planes parallel to the dial 13. To the outside of the case 12, a decorative member 21, such as a bezel, may be attached as appropriate.

The case 12 is cylindrical with the upper end and the lower end open. In the circular space (i.e., inside the case 12), for example, the following are housed; the dial 13, the hands 14, the dial cover 15 and the board 20, which are mentioned above, and a drive unit including a wheel train mechanism, which is a gear train, and a stepping motor that rotate the hands 14, and a battery 22 (rechargeable battery) . The lower end of the case 12 is sealed with the back cover 18 (shown in FIG. 2) and the upper end thereof is sealed with the crystal 17 to prevent water, dust and so forth from entering the case 12. The case 12 is not limited to but stainless steel, for example.

The dial 13 is disposed so as to be exposed to the upper end side of the case 12. On the upper surface (exposed surface) of the dial 13, indexes 131 (hour marks) for indicating time are disposed for respective hours (at intervals of 30 degrees). On the upper surface of the dial 13, marks for indicating time in units of minutes and seconds may also be disposed, for example.

The center of the dial 13 is the rotational axis of at least some of the hands 14, for example, an hour hand, a minute hand and a second hand. The other hands 14 may be small hands that rotate in small windows 132 that occupy part of the upper surface of the dial 13.

The dial 13 and the hands 14 constitute a display of this embodiment.

The dial cover 15 is an annular member disposed along the upper end of the inner circumferential surface of the case 12, and defines, from above the dial 13, a visible area of the dial 13 that a user can see. The "along the upper end of the inner circumferential surface" herein does not mean being in contact with the upper end. The upper surface of the dial cover 15 may be disposed lower than the upper end of the case 12. The dial cover 15 of the electronic timepiece 1 of this embodiment is a light-transmitting member, such as resin. The dial cover 15 does not need to be transparent, and may be a colored light-transmitting member.

The solar panel 16 is a solar cell formed of a plurality of solar cells arranged in line to be annular, and disposed under the dial cover 15 to receive light incident thereon through the dial cover 15, thereby generating electric power. The solar panel 16 may be a film-like panel, which is thinner and less rigid than a plate-like panel.

The board 20 is disposed on the back surface side (lower side) in the case 12 (on a plane different from that on which the solar panel 16 is disposed), substantially parallel to the solar panel 16 in this embodiment. To the board 20, a connector 162 continuous with a wiring plate 161, disposed at the tip of the wiring plate 161 in this embodiment, extending from the solar panel 16 is connected and fixed, so that electric power is supplied to the board 20, and electronic components connected thereto operate. The board 20 includes a CPU (microcomputer) or the like. Operation of the CPU includes operation as an electronic timepiece, namely operation as a time counter that counts current time and operation as a display controller that causes the drive unit (motor), which rotates the hands 14 in sync with the current time, to operate to cause the hands 14 to display the current time.

FIG. 2 is a sectional view of the electronic timepiece 1, perpendicular to the bottom surface and taken along line A-A in FIG. 1B. In FIG. 2, the hands 14 are omitted.

Inside the case 12, the drive unit for the hands 14 and the board 20 are disposed under the dial 13. The open lower surface (lower end) of the case 12 is sealed with the back cover 18. To the upper end of the inner circumferential surface of the case 12, the transparent crystal 17 is fitted.

The upper portion of the inner circumferential surface of the case 12 is stepwise outward, and the upper end of this portion forms an opening (open upper end/surface) of the case 12. The solar panel 16 is disposed on an annular step surface 121 with which the stepwise portion is provided. The inner diameter of the case 12 above the step surface 121 is larger than that of the case 12 under the step surface 121. The dial cover 15 disposed above the solar panel 16 is fitted in the large space, which is above the step surface 121 of the case 12, along the inner circumferential surface of the case 12 via an annular packing 19. That is, the dial cover 15 is not in direct contact with the case 12. The packing 19 is an elastic member and may be waterproof. The packing 19 deforms so as to fill the gap between the case 12 and the dial cover 15, thereby fixing the dial cover 15 to the case 12 appropriately.

The lower end of the packing 19 reaches the step surface 121, and the outer edge of the solar panel 16 is interposed and fixed between the packing 19 and the step surface 121. This makes it unnecessary to use an adhesive, such as glue or double-sided tape, to fix the solar panel 16, and accordingly does not cause deterioration in external appearance of the electronic timepiece 1 due to an adhesive being visible through the dial cover 15. Further, since no adhesive is used, the solar panel 16 hardly slides from its original position, in particular, hardly leaves the step surface 121 and comes into contact with the dial cover 15.

The packing 19 is partly interposed between the solar panel 16 and the dial cover 15, thereby separating the solar panel 16 and the dial cover 15 from one another. For this purpose, the sectional shape of the packing 19 may be L-shaped as shown in FIG. 2. Further, as shown in FIG. 2, the dimension of the interposed portion of the packing 19 between the solar panel 16 and the dial cover 15 in the horizontal direction (i.e., width thereof in the radius direction of the open surface (s) of the case 12) may be sufficiently short as compared with that of the dial cover 15. If the solar panel 16 is in contact with the dial cover 15, moire appears as viewed from the above because of refraction and interference of light between these components. Fixing the solar panel 16 and the dial cover 15 in the state in which they are separated from one another prevents moiré from appearing. If the dial cover 15 is fitted in the state of being in contact with the solar panel 16, their contact surfaces are scratched, which may lead to deterioration in the external appearance or decrease in the power generation efficiency. Separating the solar panel 16 and the dial cover 15 from one another also prevents such scratches from being made.

The packing 19 is an elastic member as described above, for example, a resin member, such as rubber. The stepwise portion of the inner circumferential surface of the case 12 has an annular depression 122 in a portion with which the packing 19 comes into contact. The packing 19 pressed by fitting of the dial cover 15 partly expands into the depression 122. This prevents (or reduces) the packing 19 from expanding and protruding upward along the inner circumferential surface of the case 12, and accordingly, if not prevents, reduces deterioration in the external appearance of the electronic timepiece 1 viewed from the above (i.e., from the upper surface side).

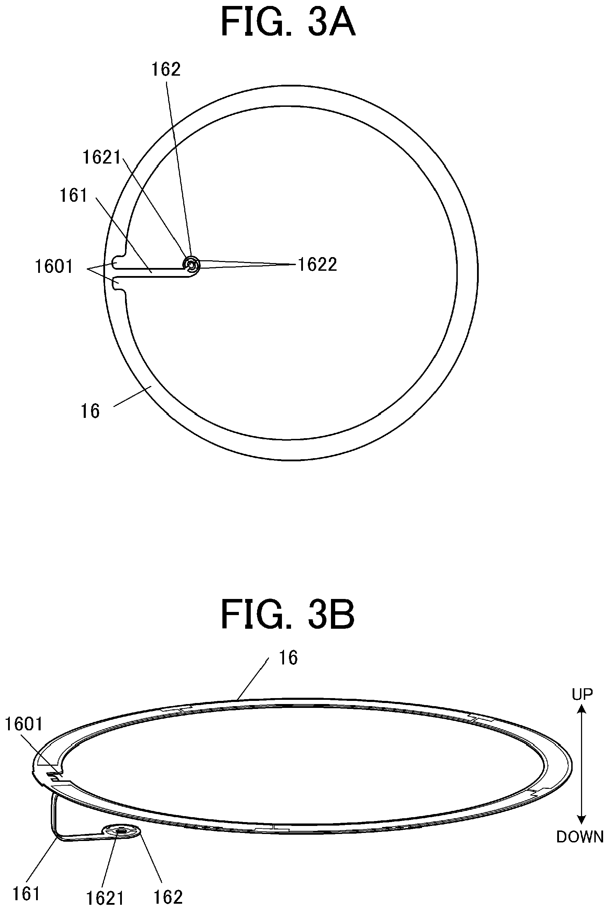

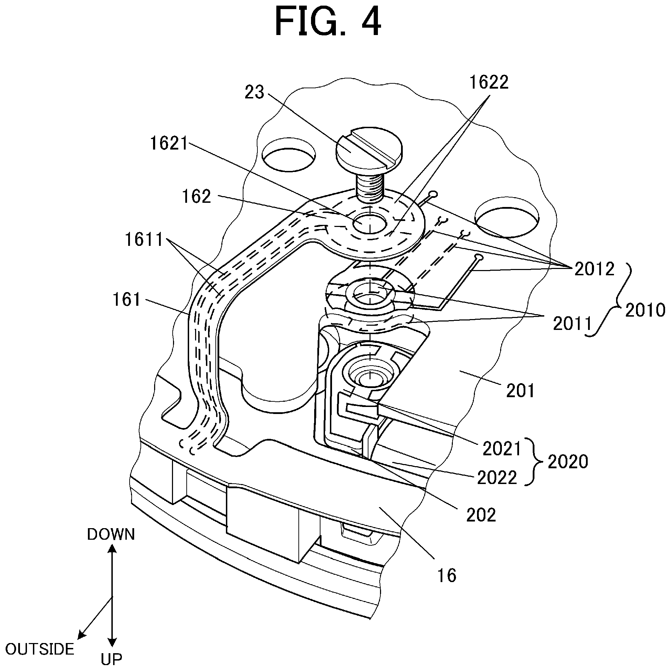

To the solar panel 16, the wiring plate 161 (wiring board), one end thereof in this embodiment, is connected, and the wiring plate 161 curvedly extends downward from this one end along the inner circumferential surface of the case 12 in the sectional view. With the wiring plate 161, the connector 162 is continuous, and a (pair of) feeder electrode(s) 1622 (shown in FIG. 3A) of the connector 162 is fixed and electrically connected to electrodes of the board 20 by a screw member 23 (fixing member or threaded member). The wiring plate 161 is flexible enough to bend, so that its curved shape is adjustable. The wiring plate 161 has two signal lines (feeder wires or feeder wiring 1611, shown in FIG. 4) extending inside or on the surface of its insulating layer, and to between the signal lines, voltage difference made in response to electric power generation is applied. Hence, the wiring plate 161 transmits electric power generated by the solar panel 16 to a power supply circuit(s) of the board 20. The screw member 23 is a component that is tightened by being rotated, such as a screw or a bolt. The screw member 23 may be made of a conductive metal normally used for common screw members.

The board 20 includes a main circuit board 201 (first circuit board) to which the CPU or the like is connected and a motor board 202 (second circuit board) for the motor of the drive unit. The electric power generated by the solar panel 16 is supplied to a power supply circuit of the main circuit board 201 and a power supply circuit of the motor board 202 in parallel via an electrode(s) of the main circuit board 201 and an electrode(s) of the motor board 202.

FIG. 3A and FIG. 3B are illustrations to explain the solar panel 16.

FIG. 3A is a plan view of the solar panel 16 detached from the electronic timepiece 1 and unfolded. FIG. 3B is a perspective view of the solar panel 16, showing the shape of the solar panel 16 in the state in which it is attached to the electronic timepiece 1.

The wiring plate 161 may be integrated with the solar panel 16. In this embodiment, the solar panel 16 has a notch 1601 in its inner edge, and the wiring plate 161 branches off at and extends from the inside of the notch 1601. That is, where the wiring plate 161 branches off from the solar panel 16 is a position outward from the inner edge of the solar panel 16, which is annular. Hence, the wiring plate 161 does not greatly protrude inward from the inner edge of the solar panel 16, namely does not protrude or, even if it does, protrudes by a small width, without making the minimum value of curvature for the curved shape of the wiring plate 161 significantly small. The wiring plate 161 interferes with arrangement of internal components as little as possible.

The connector 162, which is continuous with the wiring plate 161, is substantially circular, and has a through hole 1621 in its center for the screw member 23 to pass through. Around the through hole 1621, the feeder electrode 1622 is disposed, and this feeder electrode 1622 is continuous with the feeder wiring 1611 (shown in FIG. 4) of the wiring plate 161. The center of the connector 162 (center position of the through hole 1621) is off the extension of the center line of the wiring plate 161 in its extending direction, and the dimension (width) of the joined portion of the wiring plate 161 and the connector 162 is larger than the dimension (width) of the wiring plate 161, the dimensions/widths being substantially perpendicular to the extending direction. Since the connector 162 may slightly rotate when fixed by the screw member 23, the joined portion with the wiring plate 161 being wide prevents trouble, such as cut-off of electric power supply due to breakage thereof. The abovementioned positional relationship between the center line of the wiring plate 161 and the center of the connector 162 reduces bending load in a case where slight misalignment occurs in relative orientations of the solar panel 16 and the boards 201, 202 when they are fixed, for example. This positional relationship may be changed as appropriate depending on a relationship between the position of the wiring plate 161 in design and the position of the connector 162 in design.

The solar panel 16, the wiring plate 161 and the connector 162 constitute a power generator of this embodiment.

FIG. 4 is an illustration to explain fixation of the connector 162. FIG. 4 shows the boards 201, 202 and the connector 162 to be fixed and the screw member 23 to fix these in the state in which they are each disassembled, viewed from the underneath (i.e., from the bottom surface side or lower side).

As described above, the screw member 23 passes through the through hole 1621 of the connector 162 to fix (co-fasten) the connector 162 and boards, the main circuit board 201 and the motor board 202 in this embodiment, all together (in the state in which they are superposed on top of one another) from the underneath. On both surfaces of the main circuit board 201, which is disposed on a lower side (side close to the connector 162) between these two boards 201, 202, (pairs of) connector electrodes 2011 (first electrodes) are disposed. The connector electrode 2011 on the upper surface of the main circuit board 201 is invisible in FIG. 4 and indicated by a broken line. In this embodiment, the connector electrodes 2011 on the both surfaces are electrically connected to one another. By co-fastening, the feeder electrode 1622 (invisible in FIG. 4 and indicated by a broken line) is superposed on and comes into contact with the connector electrode 2011 on the lower surface of the main circuit board 201, thereby being electrically connected thereto. On the lower surface of the motor board 202, which is disposed on an upper side between these two boards 201, 202, a (pair of) connector electrode(s) 2021 (second electrode) is disposed for receiving electric power that the motor board 202 supplies to the motor.

By co-fastening, the connector electrode 2011 on the upper surface of the main circuit board 201 is superposed on and comes into contact with the connector electrode 2021, thereby being electrically connected thereto. The connector electrodes 2011 are continuous with power supply lines 2012 (first wires or first wiring), and these constitute a first circuit 2010. The electric power supplied from the solar panel 16 to the first circuit 2010 via the feeder wiring 1611 of the wiring plate 161 is transmitted to a power supply unit and other components of the main circuit board 201. The connector electrode 2021 is continuous with a power supply line 2022 (second wire or second wiring), and these constitute a second circuit 2020. The electric power supplied from the solar panel 16 to the second circuit 2020 via the feeder wiring 1611 and the connector electrodes 2011 is transmitted to a motor drive unit or the like for the motor board 202. The feeder electrode 1622 is disposed on, of the connector 162, only the side (upper surface) that comes into contact with the board 20 (i.e., main circuit board 201), and the side (lower surface) that comes into contact with the bearing surface of the screw member 23 is made of an insulating member and hence is not electrically connected to the screw member 23.

Since two inter-electrode gaps are fixed together by one screw member 23, electric power can be supplied with certainty, without taking up much space.

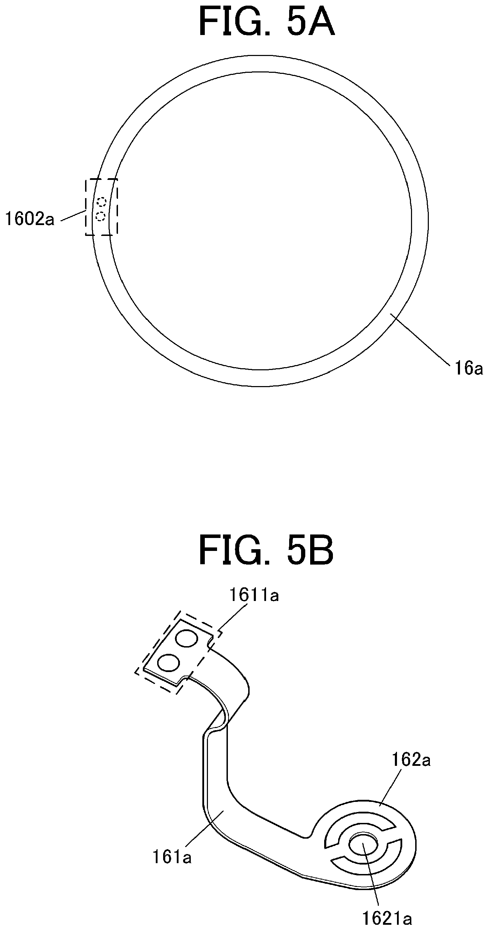

FIG. 5A and FIG. 5B are illustrations to explain a solar panel 16a and a component(s) for connecting and fixing the solar panel 16a, according to a modification.

In this modification, the solar panel 16a is configured such that a separate wiring plate 161a provided with a connector 162a is attached and fixed to a connector terminal 1602a. In this case, as shown in FIG. 5A, the solar panel 16a does not need to have the notch 1601 and instead has the connector terminal 1602a at a position on its annular shape. It is preferable that the connector terminal 1602a be disposed on the lower surface of the solar panel 16, but a terminal mark or the like may be identifiable from the upper surface side too.

As shown in FIG. 5B, at one end of the wiring plate 161a, a terminal 1611a for connecting the feeder wiring 1611 to the connector terminal 1602a is provided. The solar panel 16a and the wiring plate 161a, which is provided with the connector 162a, may be detachable from one another or, once the terminals 1602a, 1611a are joined, may not be detached any longer in a normal manner.

With the other end (tip) of the wiring plate 161a, the connector 162a is continuous. The connector 162a has a through hole 1621a in its center. The positional relationship between the wiring plate 161a and the connector 162a may be the same as or different from that of the wiring plate 161 and the connector 162.

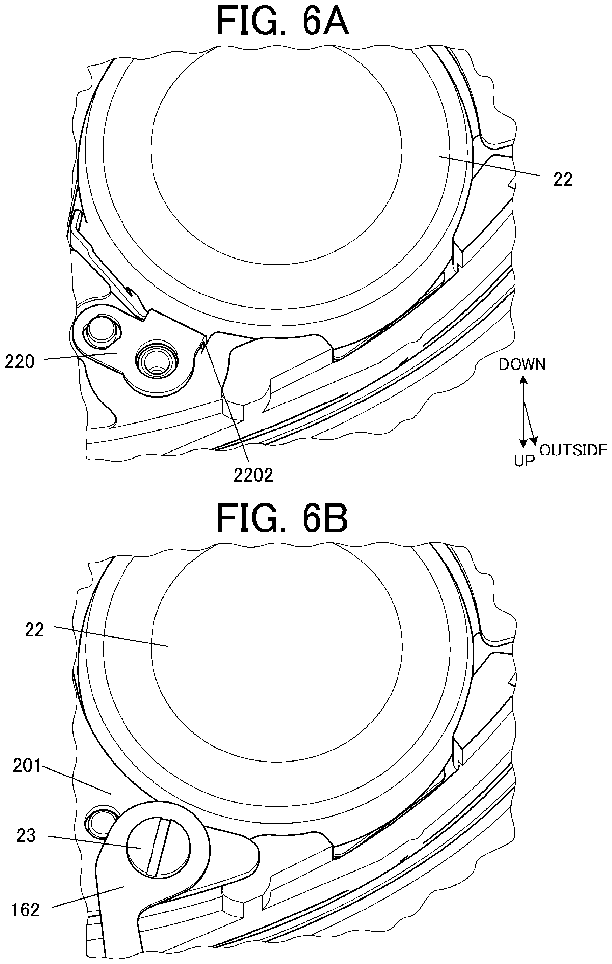

FIG. 6A and FIG. 6B show a modification of the objects to be co-fastened. For example, the connector 162, the main circuit board 201 and a connector terminal 220 for the battery 22 may be co-fastened by the screw member 23. FIG. 6A shows the connector terminal 220 without the other components related to co-fastening. FIG. 6B shows a state in which the components 162, 201, 220 are co-fastened by the screw member 23.

The connector terminal 220 shown in FIG. 6A is a conductive member, and constitutes a connector electrode to output electric power (voltage) input from the battery 22 via a power supply line 2202. As shown in FIG. 6B, the connector 162, the main circuit board 201 and the connector terminal 220 are co-fastened by the screw member 23 in the state of being superposed on top of one another in this order from the lower side, so that the feeder electrode 1622 is electrically connected to the connector electrode 2011 on the lower surface of the main circuit board 201, and the connector terminal 220 is electrically connected to the connector electrode 2011 on the upper surface of the main circuit board 201.

In this case, the power supply line(s) 2012 connected to the connector electrode 2011 on the upper surface of the main circuit board 201 and the power supply line(s) 2012 connected to the connector electrode 2011 on the lower surface of the main circuit board 201 are independently connected to the power supply unit (LSI, etc.) on the main circuit board 201. Further, in this case, the screw member 23 is insulating at least on its surface. The power supply unit charges or discharges the battery 22 depending on the magnitude of the output voltage of the battery 22 and the magnitude of the power generation voltage of the solar panel 16, for example. To each component of the main circuit board 201, electric power is supplied from either the battery 22 or the solar panel 16.

As described above, the electronic timepiece 1 of this embodiment includes: the solar panel 16; the wiring plate 161 including the feeder wiring 1161 connected to the solar panel 16; the connector 162 continuous with the wiring plate 161 and including the feeder electrode 1622 electrically connected to the feeder wiring 1611; the first circuit 2010 including the connector electrodes 2011 and the power supply lines 2012 continuous with the connector electrodes 2011; the second circuit 2020 including the connector electrode 2021 and the power supply line 2022 continuous with the connector electrode 2021; and the screw member 23 that fixes the feeder electrode 1622, the connector electrodes 2011 and the connector electrode 2021 in the state in which the electrodes 1622, 2011, 2021 are superposed on top of one another, to electrically connect each one of the electrodes 1622, 2011, 2021 to another one or more of the electrodes 1622, 2011, 2021.

Thus, the feeder electrode 1622 and other two or more electrodes are superposed on top of one another and co-fastened by one screw member 23 such that two or more inter-electrode connections are formed. This reduces space required for their connections, and more efficiently supplies electric power to each component of the electronic timepiece 1.

Further, the first circuit 2010 is disposed on the main circuit board 201, the second circuit 2020 is disposed on the motor board 202, and the screw member 23 fixes the connector 162, the main circuit board 201 and the motor board 202 in the state in which the connector 162, the main circuit board 201 and the motor board 202 are superposed on top of one another. Thus, the boards, on which the abovementioned electrodes are disposed, are fixed in the state of being superposed on top of one another. This reduces the number of screw members 23 to be used in the electronic timepiece 1 for connecting the boards having some thicknesses, and accordingly reduces the abovementioned space.

Further, the wiring plate 161 is integrated with the solar panel 16. Forming these components as a single unit is easier than not, and saves time and effort to attach the wiring plate 161 to the solar panel 16. In addition, such a wiring plate 161 is less likely to cause cut-off of electric power supply due to connection failure (e.g., poor contact).

Further, the wiring plate 161 may be bendable. This makes it easy to adjust the wiring path of the wiring plate 161. In particular, this wiring plate 161 can connect the solar panel 16 to the main circuit board 201 or the like even when they are misaligned slightly, and strain that is applied to the wiring plate 161 when they are connected is distributed appropriately. Hence, the wiring plate 161 makes it easy and simple to assemble the electronic timepiece 1. In addition, it is unlikely that durability of the wiring plate 161 greatly decreases.

Further, the solar panel 16 is annular and has the notch 1601 in its inner edge, and the wiring plate 161 extends from the notch 1601.

That is, the wiring plate 161 branches off from the solar panel 16 at a position outward from the inner edge of the solar panel 16. If the wiring plate 161 greatly protrudes inward, it could be an obstacle to arrangement of other electronic components or the like. The wiring plate 161 branching off from the solar panel 161 at a position outward from the inner edge of the solar panel 16 reduces the amount of the inward protrusion without being bent a steep angle, in particular, without being bent discontinuously, in other words, even by being bent gradually or being curved. The wiring plate 161 therefore hardly becomes an obstacle to arrangement of other components in the electronic timepiece 1, and at the same time, prevents trouble, such as cutting of the feeder wiring 1611 of the wiring plate 161.

Further, the fixing member, which fixes the connector 162, is the screw member 23 (threaded member), and the width of the joined portion of the wiring plate 161 and the connector 162 is larger than the width of the wiring plate 161, the widths being substantially perpendicular to the extending direction of the wiring plate 161. When the connector 162 is fixed by the screw member 23, force is likely to be applied to the connector 162 in its rotational direction. Making the root/base of the connector 162 wide improves durability of the connector 162 against the force in the torsional direction, and prevents trouble, such as wiring breakage.

Further, the center of the connector 162 is off the extension of the center line of the wiring plate 161. It is unnecessary for the wiring plate 161 and the connector 162 to form a straight line. Their positions (positional relationship) can be adjusted as appropriate in accordance with a positional relationship between (i) where the wiring plate 161 can pass through between the case 12 and the board 20 and (ii) where the connector 162 is actually fixed to the main circuit board 201. The connector 162 being off from the extension of the center line of the wiring plate 161 enhances durability of the connector 162 and the wiring plate 161 against the force in the torsional direction even if the force is applied to the connector 162 and the wiring plate 161.

The electronic timepiece 1 includes the CPU (microcontroller) on the main circuit board 201 as the time counter that counts the current time, and the display (dial 13 and hands 14) that displays the current time. Electronic timepieces are required to be small/lightweight and perform solid continuous operation. The electronic timepiece 1 is small and can supply electric power with certainty.

The present disclosure is not limited to the above embodiment, and various modifications can be made.

For example, in the above embodiment, the wiring plate 161 forms a straight line in its unfolded state, but not limited thereto. The wiring plate 161 may be bent in the unfolded state in its sliding direction.

Further, in the above embodiment, the feeder electrode 1622, the main circuit board 201 and another one type of electrode are co-fastened, but this is not a limitation. The feeder electrode 1622 and three or more types of electrode may be co-fastened. The order of their superposition is not limited to those described above either. For example, the feeder electrode 1622 and electrodes (terminals) may be co-fastened in the state in which the feeder electrode 1622 is interposed between the electrodes.

Further, the widths, thicknesses, sizes and so forth of the wiring plate 161 and the connector 162 may be set as appropriate to be suitable for the arrangement space inside the case 12, for example. Still further, the wiring plate 161 may not be wide partly but wholly. Yet further, the width of the wiring plate 161 may not be uniform. Further, the center of the connector 162 may be on the extension of the center line of the wiring plate 161.

Further, the solar panel 16 being integrated with the wiring plate 161 does not require itself to have the notch 1601. Still further, if there is some room not inside but outside the solar panel 16, the notch 161 may be provided in the outer edge of the solar panel 16.

Further, in the above embodiment, the connector 162 has the through hole 1621 in its center for the screw member 23 to pass through, but not limited thereto. For example, the connector 162 may have a U-shaped notch (recess) for the screw member 23 to pass through.

Further, the wiring board may not be plate-like (belt-shaped) like the wiring plate 161. For example, the sectional shape of the wiring board may be a circle, an oval, two circles joined together, a square, a square with rounded corners, or the like.

Further, the "annular" is not limited to being a perfect circle. The "annular" could indicate a shape having portions of different curvatures, steeply-bent portions (portions having angles) and/or straight portions.

Further, in the above embodiment, the solar panel 16 is disposed under the light-transmitting dial cover 15, but not limited thereto. For example, the solar panel 16 may be disposed under a light-transmitting portion of the dial 13. Still further, the solar panel 16 may be supported not by the step surface 121 of the case 12 but by another member. Yet further, the solar panel 16 may not be fixed by the packing 19 but adhesively fixed by an adhesive. Further, the solar panel 16 may not be completely circumferential or annular, but have some cuts in its annular shape.

Further, in the above embodiment, co-fastening is performed by the screw member 23 as the threaded member. However, even if the connector 162 (feeder electrode 1622), the main circuit board 201 (connector electrodes 2011), the motor board 202 (connector electrode 2021) and/or the like are fixed by another type of fixing member, such as solder, the thickness of these components as a whole can be made smaller, and accordingly the space required for their connections can be reduced.

Further, in the above embodiment, the wiring plate 161 is flexible, so that its curved shape is adjustable. However, if misalignment of the solar panel 16 and the main circuit board 201 or the like is unlikely to occur, the wiring plate 16 may have a fixed shape along the wiring path between, for example, the connection position thereof to the solar panel 16 and the connection position thereof to the main circuit board 201. Still further, the wiring plate 161 may be flat or have some steep bends.

Further, like the modification, if the connector electrodes on the boards 201, 202 that are electrically connected to one another but not to the feeder electrode 1622 are included in those co-fastened (fixed in the state of being superposed on top of one another), the connector electrodes do not transmit electric power therebetween, but may constitute a transmission path of another signal.

Further, although the electronic device of the above embodiment is the electronic timepiece 1, it may be another type of electronic device. Further, the electronic timepiece 1 may not have hands, but have a digital display screen to display time digitally.

Other specific configurations, components, contents and procedures of the processes, and so forth described in the above embodiment can be modified as appropriate without departing from the scope of the present disclosure.

Although one or more embodiments of the present disclosure have been described above, the scope of the present disclosure is not limited to the embodiments, but includes the scope of claims and the scope of their equivalents.

## Claims

1. An electronic device (1) comprising:
a solar cell (16, 16a);
a wiring board (161, 161a) including a feeder wiring (1611) connected to the solar cell;
a connector (162, 162a) continuous with the wiring board and including a feeder electrode (1622) electrically connected to the feeder wiring;
a first circuit (2010) including a first electrode (2011) and a first wiring (2012) continuous with the first electrode;
a second circuit (2020) including a second electrode (2021) and a second wiring (2022) continuous with the second electrode; and
a fixing member (23) that fixes the feeder electrode, the first electrode and the second electrode in a state in which the electrodes are superposed on top of one another, to electrically connect each one of the electrodes to another one or more of the electrodes.

2. The electronic device according to claim 1,
wherein the first circuit is disposed on a first circuit board (201),
wherein the second circuit is disposed on a second circuit board (202), and
wherein the fixing member fixes the connector, the first circuit board and the second circuit board in the state in which the connector, the first circuit board and the second circuit board are superposed on top of one another.

3. The electronic device according to claim 1 or 2, wherein the wiring board is integrated with the solar cell.

4. The electronic device according to any one of claims 1 to 3, wherein the wiring board is bendable.

5. The electronic device according to claim 4,
wherein the solar cell is annular and has a notch (1601) in an inner edge thereof, and
wherein the wiring board extends from the notch.

6. The electronic device according to any one of claims 1 to 5,
wherein the fixing member is a threaded member, and
wherein a width of a joined portion of the wiring board and the connector is larger than a width of the wiring board, the widths being substantially perpendicular to an extending direction of the wiring board.

7. The electronic device according to any one of claims 1 to 6, wherein a center of the connector is off an extension of a center line of the wring board.

8. The electronic device according to any one of claims 1 to 7, comprising:
a time counter that counts current time; and
a display (13, 14) that displays the current time.
